# EUROPEAN PATENT APPLICATION

(11) **EP 2 624 281 A1**
(43) Date of publication of application: **07.08.2013**
(21) Application number: 11828386.0
(22) Date of filing: 26.09.2011
(51) Int. Cl.: H01L 21/027, B29C 33/38, B29C 59/02, G11B 5/84

(54) **NANOIMPRINTING MOLD, METHOD OF MANUFACTURING THEREOF, AND NANOIMPRINTING METHOD**

(30) Priority: 29.09.2010 JP 2010218527
(71) Applicant: FUJIFILM Corporation, Tokyo 106-8620 (JP)
(72) Inventor: SATOU, Naotoshi, Minamiashigara-shi Kanagawa 250-0123 (JP)
(74) Representative: HOFFMANN EITLE
(86) International application number: PCT/JP2011/005384
(87) International publication number: WO 2012/042820

(57) **Abstract**

[Objective]

To enable fluctuations in the thickness of resist films after imprinting to be eliminated, in a Nanoimprinting method that employs a fine pattern of protrusions and recesses.

[Constitution]

A nanoimprinting mold (10) is produced by forming a fine pattern of protrusions and recesses on the surface of a substrate. A substrate (12) having a surface shape after a mold release process is administered thereon and before the pattern of protrusions and recesses is formed with a 3σ value related to a height difference distribution within a range from 1nm to 3nm is employed as the substrate.

## Description

### BACKGROUND OF THE INVENTION

### Field of the Invention

The present invention is related to a nanoimprinting mold having a pattern of protrusions and recesses corresponding to or inverse to a predetermined pattern of protrusions and recesses, a method for producing the nanoimprinting mold, and a Nanoimprinting method that employs the nanoimprinting mold.

### Description of the Reflated Art

There are high expectations regarding utilization of pattern transfer techniques that employ a Nanoimprinting method to transfer patterns onto resist coated on objects to be processed, in applications to produce magnetic recording media such as DTM (Discrete Track Media) and BPM (Bit Patterned Media) and semiconductor devices.

Nanoimprinting is a pattern forming technique which was developed based on embossing techniques which are well known in the production of optical disks. Specifically, in the nanoimprinting method, a mold (commonly referred to as a mold, a stamper, or a template), on which a pattern of protrusions and recesses is formed, is pressed against resist coated on a substrate, which is an object to be processed. Pressing of the original onto the resist causes the resist to mechanically deform or to flow, to precisely transfer the fine pattern. If a mold is produced once, nano level fine structures can be repeatedly molded in a simple manner. Therefore, the nanoimprinting method is an economical transfer technique that produces very little harmful waste and discharge. Therefore, there are high expectations with regard to application of the nanoimprinting method in various fields.

Conventionally, the aforementioned nanoimprinting method performs pattern transfer by uniformly coating an object to be processed with resist to form a resist film, and then pressing a patterned surface of a mold having a pattern of protrusions and recesses thereon against the resist film.

However, there are cases in which fluctuations in the thickness of the resist film onto which the pattern has been transferred occur, according to the surface shape of a substrate. Here, the expression "fluctuations in the thickness of the resist film" refers to fluctuations among the thicknesses of the protrusions and the recesses within a region in which the pattern of protrusions and recesses is present. The expression "fluctuations in the thickness of the resist film" also refers to fluctuations in the thickness of the resist film at two arbitrary points in regions in which the pattern of protrusions and recesses is not present. That is, the expression fluctuations in the thickness of the resist film" refers to non uniformity in the thickness of the resist film. Such fluctuations in the thickness of resist film following imprinting influence steps that follow thereafter (a step of etching the object to be processed, etc,), and deteriorate the ultimate pattern transfer accuracy.

Therefore, Patent Document 1 discloses a method in which the aforementioned fluctuations in the thickness of resist film is reduced, by defining the 10 point average surface roughness at the peaks of protrusions and the bottoms of recesses of a pattern of protrusions and recesses.

### [Prior Art Documents]

### [Patent Documents]

[Patent Document 1] Japanese Unexamined Patent Publication No. 2008-276907

### Disclosure of the Invention

However, there is a problem that it is difficult for the method of Patent Document 1 to reduce the fluctuations in the thickness of resist film to a degree that is required in the production of media that employ transfer techniques of patterns which are fine to the order of several tens of nanometers. Accordingly, a method that more positively reduces fluctuations in the thickness of resist film following imprinting is desired for nanoimprinting methods that employ fine patterns of protrusions and recesses.

The present invention has been developed in view of the foregoing circumstances. It is an object of the present invention to provide a nanoimprinting mold that more positively reduces fluctuations in the thickness of resist film following imprinting, even in a nanoimprinting method that employs fine patterns of protrusions and recesses. It is another object of the present invention to provide a method for producing the Nanoimprinting mold. It is still another object of the present invention to provide a nanoimprinting method that employs the nanoimprinting mold.

A nanoimprinting mold of the present invention that achieves the above object is produced by forming a fine pattern of protrusions and recesses on the surface of a substrate, wherein:
the surface shape of the substrate after a mold release process is administered thereon and before the pattern of protrusions and recesses is formed is that which has a 3σ value related to a height difference distribution within a range from 1nm to 3nm.

In the present specification, the expression "height difference distribution" refers to a distribution in height differences using an average value of the heights of a surface shape as a standard.

The term "3σ value" refers to the absolute value within a range of ±3σ from an average value when the height difference distribution approximates a Gaussian distribution. Here, σ is a standard deviation in the Gaussian distribution.

In the nanoimprinting mold of the present invention, it is preferable for the 3σ value to be within a range from 1nm to 2nm.

It is preferable for the 3σ value to be a value which is calculated as a result of performing measurements of the surface shape over a range having an area of at least 30mm square.

It is preferable for the substrate having the surface shape to be produced employing a Si substrate, formed by performing CMP (Chemical Mechanical Polishing) on the Si substrate using alkaline colloidal silica and a polyurethane foam pad at a polishing pressure within a range from 60g/cm² to 80g/cm² and a polishing time within a range from 450 seconds to 800 seconds, and then administering a mold release process thereon.

Further, a method for producing a nanoimprinting mold of the present invention is that in which a fine pattern of protrusions and recesses is formed on the surface of a substrate, wherein:
the surface shape of the substrate after a mold release process is administered thereon and before the pattern of protrusions and recesses is formed is that which has a 3σ value related to a height difference distribution within a range from 1nm to 3nm.

In the method for producing a nanoimprinting mold of the present invention, it is preferable for a substrate having the 3σ value within a range from 1nm to 2nm to be employed as the substrate.

It is preferable for the 3σ value to be a value which is calculated as a result of performing measurements of the surface shape over a range having an area of at least 30mm square.

It is preferable for the substrate having the surface shape to be produced employing a Si substrate, formed by performing chemical mechanical polishing on the Si substrate using alkaline colloidal silica and a polyurethane foam pad at a polishing pressure within a range from 60g/cm² to 80g/cm² and a polishing time within a range from 450 seconds to 800 seconds, and then administering a mold release process thereon.

Further, a nanoimprinting method of the present invention employs the nanoimprinting mold of the present invention;
forms a resist film on a surface to be processed of a member to be processed;
presses the pattern of protrusions and recesses of the nanoimprinting mold against the resist film, to transfer the pattern of protrusions and recesses onto the resist film; and
separates the nanoimprinting mold from the resist film.

The nanoimprinting mold and the method for producing the nanoimprinting mold of the present invention employ the substrate having a surface shape on a pattern formation surface after a mold release process is administered thereon and before the pattern of protrusions and recesses is formed with a 3σ value related to a height difference distribution within a range from 1nm to 3nm as the substrate of the nanoimprinting mold. Therefore, fluctuations in the surface shape of the nanoimprinting mold can be reduced. As a result, fluctuations in the thickness of resist film following imprinting, even in a nanoimprinting method that employs fine patterns of protrusions and recesses can be more positively reduced.

The nanoimprinting method of the present invention employs the Nanoimprinting mold which is produced using the substrate having a surface shape on a pattern formation surface after a mold release process is administered thereon and before the pattern of protrusions and recesses is formed with a 3σ value related to a height difference distribution within a range from 1nm to 3nm as the substrate of the nanoimprinting mold. Accordingly, fluctuations in the thickness of resist film following imprinting, even in a nanoimprinting method that employs fine patterns of protrusions and recesses can be more positively reduced by the use of the nanoimprinting mold, in which fluctuations in the surface shape thereof are reduced.

### Brief Description of the Drawings

Figure 1 is a schematic diagram that illustrates the surface of a nanoimprinting mold according to an embodiment of the nanoimprinting mold, on which a pattern of protrusions and recesses is formed.
Figure 2 is a schematic diagram that illustrates the entire structure of the nanoimprinting mold according to the embodiment of the nanoimprinting mold.
Figure 3A is a first conceptual diagram for explaining how fluctuations in the surface shape of a substrate, which is the base for a nanoimprinting mold, influences fluctuations in protrusions and recesses on the surface of the nanoimprinting mold.
Figure 3B is a second conceptual diagram for explaining how fluctuations in the surface shape of a substrate, which is the base for a nanoimprinting mold, influences fluctuations in protrusions and recesses on the surface of the Nanoimprinting mold.
Figure 4A is a first diagram that illustrates evaluation criteria for fluctuation in the thickness of a resist film following imprinting.
Figure 4B is a second diagram that illustrates evaluation criteria for fluctuation in the thickness of a resist film following imprinting.
Figure 4C is a third diagram that illustrates evaluation criteria for fluctuation in the thickness of a resist film following imprinting.

Best Mode for carrying out the Invention Hereinafter, embodiments of the present invention will be described with reference to the attached drawings. However, the present invention is not limited to the embodiments to be described below. Note that in the drawings, the dimensions of the constitutive elements are drawn differently from the actual dimensions thereof, in order to facilitate visual understanding thereof.

### [Embodiment of Nanoimprinting Mold and Method for Producing the Nanoimprinting Mold]

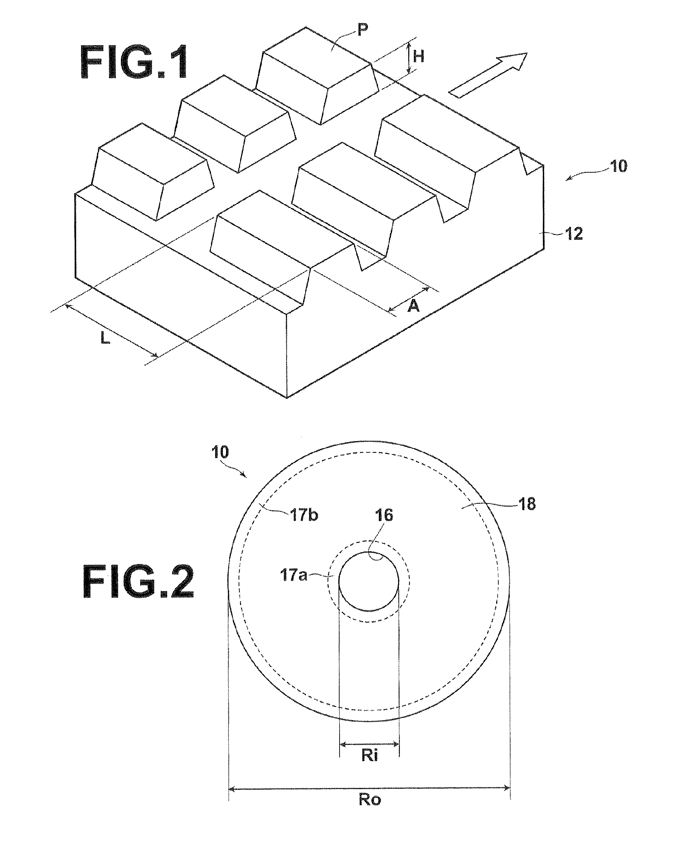

Figure 1 is a partial enlarged perspective view of a nanoimprinting mold 10, and Figure 2 is a plan view that illustrates the entire structure of the Nanoimprinting mold of Figure 1.

As illustrated in Figure 1, the nanoimprinting mold 10 of the present embodiment is constituted by a substrate 12. A fine pattern of protrusions and recesses corresponding to information to be transferred is provided on the surface of the substrate 12.

The protrusions of the pattern P of fine protrusions and recesses are rectangular in plan view. The length A in the track direction (the circumferential direction of the disk, indicated by the arrow in Figure 1), the length L in the track width direction (the radial direction of the disk), and the height H (thickness) of each protrusion are set as appropriate according to recording density, recording signal waveforms, etc. For example, the length A may be set to be 80nm, and the length L may be set to be 200nm. In the case that the information to be transferred is servo signals of a magnetic disk to be employed as a hard disk device, the length L in the track width direction is set longer than the length A in the track direction A in the pattern P of fine protrusions and recesses. It is preferable for the length L in the track width direction to be within a range from 0.05µm to 20µm and for the length A in the track direction to be within a range from 0.05µm to 5µm, for example. Patterns with protrusions having greater lengths in the track width direction are preferable as patterns that bear information corresponding to servo signals. The height H of the protrusions (the depth of the recesses of the pattern) is preferably within a range from 20nm to 800nm, and more preferably within a range from 30nm to 600nm.

In addition, the shape of the nanoimprinting mold 10 as a whole is a discoid disk having an outer diameter Ro, an inner diameter Ri, and a central aperture 16, as illustrated in Figure 2. The pattern P of protrusions and recesses illustrated in Figure 1 is formed in an annular region 18 excluding an inner peripheral portion 17a and an outer peripheral portion 17b on one surface of the nanoimprinting mold 10.

The nanoimprinting mold 10 of the present embodiment employs a substrate having a surface shape after a mold release process is administered thereon and before the pattern of protrusions and recesses is formed with a 3σ value related to a height difference distribution within a range from 1nm to 3nm as the substrate 12. A photoresist film is provided on the surface having the aforementioned surface shape. The photoresist film is exposed and drawn by an electron beam at portions corresponding to the pattern of protrusions and recesses. The exposed portions of the photoresist film are removed by a developing process, and the nanoimprinting mold 10 is produced by etching the substrate 12 using the remaining photoresist as a mask by RIE (Reactive Ion Etching), for example.

The material of the substrate 12, which is the base of the nanoimprinting mold, is not particularly limited, and may be selected as appropriate according to intended use. Examples of favorable materials include: Si, Si oxide, Si nitride, quartz, metal, and resin. Examples of metal materials include: metals, such as Ni, Cu, Al, Mo, Co, Cr, Ta, Pd, Pt, Au, etc.; and alloys thereof. From among the metal materials, Ni and Ni alloys are particularly preferable. Examples of resin materials include: PET (polyethylene terephthalate); PEN (polyethylene naphthalate); PC (polycarbonate); PMMA (polymethyl methacrylate) ; TAC (triacetate cellulose); low melting point fluorine resin; etc.

The substrate 12 is designed to have a 3σ value related to a height difference distribution within a range from 1nm to 3nm, in order to reduce fluctuations in the surface shape of the Nanoimprinting mold which is produced employing the substrate 12. A more preferable range for the 3σ value is 1nm to 2nm. The 3σ value of the shape of the surface is measured with NewView 6300 by ZYGO CORPORATION.

It is preferable for the 3σ value to be calculated after the surface shape is measured for at least a 30mm square range. Here, the measurement range is more preferably 40mm square, and most preferably 50mm square. These measurement ranges are preferred because height differences between two points which are comparatively remote from each other at a distance of approximately 1mm can be reduced, by analyzing a more macroscopic range as the subject of evaluation of the height difference distribution of the surface shape. In addition, evaluations of fluctuations in the thickness of the photoresist film and of imprinting defects within a range corresponding to the entire region of a single semiconductor chip will be more reliable, taking the fact that a common size of a single semiconductor chip is 26mm·33mm.

For example, the roughness of a pattern of protrusions and recesses of a nanoimprinting mold is measured by an AFM (Atomic Force Microscope) in Patent Document 1. However, the range of this measurement is an extremely small range which is capable of being measured by the AFM, and is approximately 0.1mm square at most. The range which is the target of evaluation in Patent Document 1 is extremely small compared to the size of the aforementioned semiconductor chip. Accordingly, it is considered that it is difficult for the method of Patent Document 1 to accurately evaluate fluctuations in the thickness of resist film and imprinting defects across a range corresponding to the entirety of a single chip. Further, this difficulty is considered to become significant in a nanoimprinting method that transfers a fine pattern of protrusions and recesses (for example, a pattern of protrusions and recesses having lines/spaces=10nm/10nm), because the allowable range of fluctuations in the thickness of resist film is narrow.

The surface shape is measured after administering CMP (Chemical Mechanical Polishing) and after a mold release process is administered. The conditions for CMP and the mold release process are adjusted as appropriate according to the material of the substrate.

For example, in the case that the material of the substrate is Si, CMP is administered using alkaline colloidal silica and a polyurethane foam pad at a polishing pressure within a range from 60g/cm² to 80g/cm² and a polishing time within a range from 450 seconds to 800 seconds. Here, it is preferable for the particle size of the alkaline colloidal silica to be within a range from 10nm to 100nm, and more preferably approximately 40nm. It is preferable for the pH of the alkaline colloidal silica to be within a range from 9 to 11.

Meanwhile, the mold release process is not particularly limited, and is administered by spin coating a mold release material onto the substrate which is the base of the nanoimprinting mold, or by immersing the substrate which is the base of the nanoimprinting mold in a solution that contains a mold release material. The mold release material is not particularly limited, and fluorine series resins, hydrocarbon series lubricants, fluorine series lubricants, fluorine series silane coupling agents, etc. may be employed. More specifically, Durasurf™ HD-1101Z diluted to a concentration of 25% by OPTOOL™ HD-ZV by Daikin Industries, ltd. may be utilized as the mold release material. The mold release process was administered by immersing the substrate which is the base of the nanoimprinting mold in the mold release material at an immersion speed of 15mm/sec and a draw up speed of 5mm/sec, and then by rinsing the substrate which is the base of the nanoimprinting mold in Vertrel™ XF-UP by Du pont-Mitsui Florochemicals Company, Ltd. at an immersion speed of 15mm/sec and a draw up speed of 5mm/sec.

The photoresist film is not particularly limited, and may be formed by common materials and methods. Examples of the material of the photoresist film include: thermoplastic resins, thermocuring resins, photocuring resins, and resist compositions that include any of the above. The photoresist film may be formed by the coating method or the ink jet method.

Hereinafter, the operational effects of the nanoimprinting mold 10 and the method for producing the nanoimprinting mold of the present invention will be described. As a result of focused research, the present inventors found that fluctuations in the thickness of resist film following imprinting are greatly influenced by fluctuations in the surface shape of the nanoimprinting mold 10. It was also found that the fluctuations in the surface shape of the nanoimprinting mold 10 are caused by the surface shape of a pattern formation surface of the substrate 12, which is the base of the nanoimprinting mold 10, after a mold release process and before a pattern is formed thereon. Here, the "fluctuations in the surface shape" of the nanoimprinting mold refers to non uniformity in the surface shape of the nanoimprinting mold, including fluctuations among the heights of the protrusions and the depths of the recesses within a region in which the pattern of protrusions and recesses is present, and fluctuations in the heights of two arbitrary points in regions in which the pattern of protrusions and recesses is not present. Meanwhile, the "fluctuations in the surface shape" of the substrate which is the base of the nanoimprinting mold refers to non uniformity in the surface shape of the substrate which is the base of the nanoimprinting mold, including fluctuations in the heights of two arbitrary points after a mold release process is administered and before a pattern of protrusions and recesses is formed thereon.

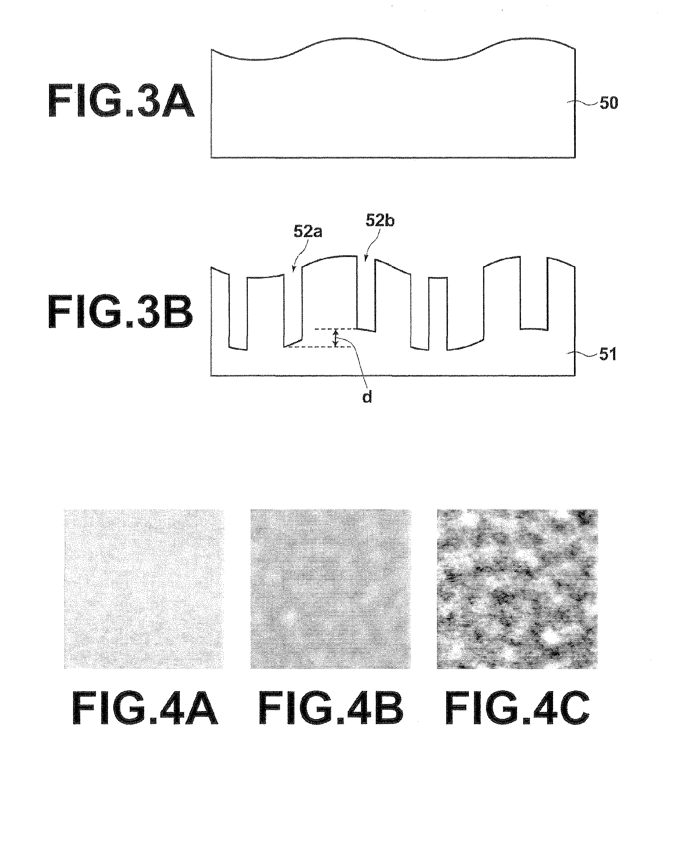

Figure 3A and Figure 3B are conceptual diagrams for explaining how fluctuations in the surface shape of a substrate 50, which is the base for a nanoimprinting mold 51, influences fluctuations in protrusions and recesses on the surface of the nanoimprinting mold 51. As illustrated in Figure 3A and Figure 3B, in the case that there are fluctuations in the surface shape of the substrate 50 and the surface having such a surface shape is processed to form a pattern of protrusions and recesses, the fluctuations in the surface shape are reflected in the surface shape of the mold 51. For example, as illustrated in Figure 3B, in the case that the depth of a recess 52a and the depth of a recess 52b within the pattern of protrusions and recesses are compared, a maximum difference of d between the depths is present due to the fluctuations in the surface shape of the mold 51. Fluctuations in the thickness of resist film following imprinting will be generated by executing nanoimprinting using the nanoimprinting mold 51 having the fluctuations in the surface shape thereof.

In order to reduce fluctuations in the surface shape of the substrate which is the base of the nanoimprinting mold, it is necessary to improve the uniformity of the surface shape of the substrate. However, there is a possibility that excessively improving the uniformity of the surface shape of the substrate will result in inhibiting the ability of resist material to flow during imprinting. Such inhibition may cause imprinting defects (defects in a pattern of protrusions and recesses when the nanoimprinting mold is separated) due to the resist material not reaching all parts of a pattern formation region. In addition, excessively improving the uniformity of the surface shape of the substrate will unnecessarily increase manufacturing costs, which is not favorable.

Taking the aforementioned problems into consideration, the present invention determines the requirements that define an appropriate degree of flatness to be a surface shape having a 3σ value related to a height difference distribution within a range from 1nm to 3nm after a mold release process is administered thereon and before the pattern of protrusions and recesses is formed. The upper limit value for the 3σ value of "3nm" is based on the fact that if the 3σ value exceeds this upper limit, fluctuations in the height of a resist mask corresponding to fluctuations in the thickness of resist film will be generated, and a uniform pattern cannot be obtained. Meanwhile, the lower limit value for the 3σ value of "1nm" is based on the fact that if the 3σ value is less than this lower limit value, the flow of resist material during imprinting will be inhibited.

As described above, the nanoimprinting mold and the method for producing the nanoimprinting mold of the present invention employ the substrate having a surface shape on a pattern formation surface after a mold release process is administered thereon and before the pattern of protrusions and recesses is formed with a 3σ value related to a height difference distribution within a range from 1nm to 3nm as the substrate of the nanoimprinting mold. Therefore, fluctuations in the surface shape of the nanoimprinting mold can be reduced. As a result, fluctuations in the thickness of resist film following imprinting, even in a nanoimprinting method that employs fine patterns of protrusions and recesses can be more positively reduced.

### [Embodiment of Nanoimprinting Method]

A nanoimprinting method of the present embodiment employs the nanoimprinting mold which is produced using the substrate having a surface shape on a pattern formation surface after a mold release process is administered thereon and before the pattern of protrusions and recesses is formed with a 3σ value related to a height difference distribution within a range from 1nm to 3nm as the substrate of the nanoimprinting mold. Specifically, the nanoimprinting method of the present embodiment employs the Nanoimprinting mold of the present invention having the fine pattern of protrusions and recesses corresponding to information to be transferred on a surface thereof, performs a mold release process on the surface of the nanoimprinting mold having the pattern of protrusions and recesses thereon, forms a resist film on a member to be processed, presses the pattern of protrusions and recesses of the nanoimprinting mold against the resist film to transfer the pattern of protrusions and recesses onto the resist film, then separates the Nanoimprinting mold form the resist film. It is preferable for a step that removes residual film to be executed as necessary.

The nanoimprinting mold of the present invention is that which has been described above.

The mold release process is not particularly limited. The mold release process which was described with respect to the substrate, which is the base of the nanoimprinting mold, is applied to the nanoimprinting mold, and administered in a similar manner.

With respect to the resist film, the resist film is the same as that described with respect to the embodiment of the nanoimprinting mold and the method for producing the nanoimprinting mold.

As described above, the nanoimprinting method of the present invention employs the nanoimprinting mold which is produced using the substrate having a surface shape on a pattern formation surface after a mold release process is administered thereon and before the pattern of protrusions and recesses is formed with a 3σ value related to a height difference distribution within a range from 1nm to 3nm as the substrate of the nanoimprinting mold. Accordingly, fluctuations in the thickness of resist film following imprinting, even in a nanoimprinting method that employs fine patterns of protrusions and recesses can be more positively reduced by the use of the nanoimprinting mold, in which fluctuations in the surface shape thereof are reduced.

### [Examples]

Examples of the nanoimprinting mold of the present invention will be described below.

### <Example 1>

CMP was performed on a Si substrate (by Fujimi Fine Technology Inc.) using alkaline colloidal silica (particle size: 40nm) and a polyurethane foam pad with a polishing pressure of 60g/cm² and a polishing time of 800 seconds. Thereafter, cleansing was performed to clean the surface of the substrate. Next, a mold release process as administered on the substrate. At this time, the 3σ value related to the height difference distribution of the surface of the substrate was 1nm. NewView 6300 by ZYGO CORPORATION was the apparatus used to evaluate the surface shape. In addition, the target range for evaluation at this time was set to an area 50mm square so as to be able to sufficiently cover the area of a single semiconductor chip. Next, a mold release material, which was formed as a film by the mold release process, was removed. Then, the substrate underwent a thermal oxidation process to form a 1.00nm thick SiO₂ film on the surface of the substrate. An electron resist film was formed on this surface, patterning was performed using an electron beam lithography apparatus, and the electron beam resist was removed at the patterned portions. An RIE process was performed using the remaining electron beam resist as a mask to form a pattern of protrusions and recesses for nanoimprinting on the surface of the Si substrate, and a Si mold was produced. The pattern of protrusions and recesses is a pattern having lines/spaces=10nm/10nm.

Here, an AFM was employed to measure a 10 point average roughness (Rz1) of the peaks of the protrusions of the pattern of protrusions and recesses, and to measure a 10 point average roughness (Rz2) of the bottoms of the recesses of the pattern of protrusions and recesses according to the method disclosed in Patent Document 1.

Next, a mold release process was administered on the surface of the Si mold using a fluorine series material. An imprinting resist liquid was coated on a quartz substrate to form a resist film. The Si mold was pressed against the resist film, then UV light was irradiated to cure the resist films. Thereafter, the Si mold was separated from the resist film, and a resist film having the pattern of protrusions and recesses transferred thereon was formed on the quartz substrate.

### <Example 2>

A resist film having the pattern of protrusions and recesses transferred thereon was formed by the same steps as those of Example 1, except that the polishing time was 600 seconds during CMP. The 3σ value related to a height difference distribution was 2nm in this example.

### <Example 3>

A resist film having the pattern of protrusions and recesses transferred thereon was formed by the same steps as those of Example 1, except that the polishing pressure was 80g/cm² and the polishing time was 450 seconds during CMP. The 3σ value related to a height difference distribution was 3nm in this example.

### Comparative Example 1>

A resist film having the pattern of protrusions and recesses transferred thereon was formed by the same steps as those of Example 1, except that a Si substrate was utilize as is, without performing CMP. The 3σ value related to a height difference distribution was 202nm in this comparative example.

### comparative Example 2>

A resist film having the pattern of protrusions and recesses transferred thereon was formed by the same steps as those of Example 1, except that the polishing pressure was 600g/cm² and the polishing time was 60 seconds during CMP. The 3σ value related to a height difference distribution was 10nm in this comparative example.

### <Comparative Example 3>

A resist film having the pattern of protrusions and recesses transferred thereon was formed by the same steps as those of Example 1, except that the polishing pressure was 300g/cm² and the polishing time was 120 seconds during CMP. The 3σ value related to a height difference distribution was 8nm in this comparative example.

### <Comparative Example 4>

A resist film having the pattern of protrusions and recesses transferred thereon was formed by the same steps as those of Example 1, except that the polishing pressure was 120g/cm2 and the polishing time was 300 seconds during CMP. The 3σ value related to a height difference distribution was 5nm in this comparative example.

### Comparative Example 5>

A resist film having the pattern of protrusions and recesses transferred thereon was formed by the same steps as those of Example 1, except that the polishing pressure was 100g/cm² and the polishing time was 360 seconds during CMP. The 3σ value related to a height difference distribution was 4nm in this comparative example.

### comparative Example 6>

A resist film having the pattern of protrusions and recesses transferred thereon was formed by the same steps as those of Example 1, except that the polishing pressure was 60g/cm² and the polishing time was 1200 seconds during CMP. The 3σ value related to a height difference distribution was 0.5nm in this comparative example.

### <Evaluation Method>

Evaluation of fluctuations in the thickness of resist films after imprinting operations was performed visually by ten people. Specifically, if the surface shape was as that illustrated in Figure 4A, it was judged that fluctuations are not present in the thickness of resist film, and an evaluation of "○" was rendered. If the surface shape was as that illustrated in Figure 4B, it was judged that fluctuations in the thickness of resist film were reduced to a certain degree, and an evaluation of "Δ" was rendered. If the surface shape was as that illustrated in Figure 4C, it was judged that fluctuations in the thickness of resist film were not reduced, and an evaluation of "×" was rendered.

Imprinting defects were evaluated as follows. If the resist material reached all parts of the entirety of the patterned region of the Si substrate, it was judged that no imprinting defects were present, and an evaluation of "○" was rendered. If flow of the resist material was inhibited and imprinting defects occurred, an evaluation of "×" was rendered.

A total evaluation of "○" was rendered in cases that "○" evaluations were obtained for both the fluctuations in thickness and imprinting defects, as such cases achieve the object of the present invention, which is to "positively reduce fluctuations in the thickness of resist film following imprinting, even in a nanoimprinting method that employs fine patterns of protrusions and recesses". A11 other cases were judged as not having achieved the object of the present invention, and were evaluated as "×".

### <Results>

Table 1 shows the 3σ values related to the surface shapes of each of the Si molds produced as Examples 1 through 3 and Comparative Examples 1 through 6, and evaluation results regarding each of the Examples and Comparative Examples. In addition, reference values Rz1 and Rz2 related to the surface shapes of nanoimprinting molds obtained by the method of Patent Document 1 are also shown in Table 1 as targets for comparison.

From the results of Table 1, evaluations indicating that fluctuations in the thickness of resist film following imprinting were reduced were obtained for Examples 1 through 3, that is, in cases that the 3σ value was within a range from 1nm to 3nm. In addition, Examples 1 through 3 also obtained total evaluations indicating that they achieved the object of the present invention. That is, it was proven that use of the nanoimprinting mold of the present invention enables positive reduction of fluctuations in the thickness of resist film following imprinting, even in a Nanoimprinting method that employs fine patterns of protrusions and recesses.

Meanwhile, the characteristic feature of the nanoimprinting mold of Patent Document 1 is that the reference values Rz1 and Rz2 respectively being within a range from 0.5nm to 20nm. The reference values Rz1 and Rz2 were 0.5nm for all of Examples 1 through 3 and Comparative Examples 1 through 6. However, it was understood that merely having this characteristic feature did not reduce fluctuations in the thickness of resist film to a level required by nanoimprinting that employs a fine pattern of protrusions and recesses. As a result, it was proven that use of the nanoimprinting mold of the present invention enables positive reduction of fluctuations in the thickness of resist film following imprinting.

**TABLE 1**

| | 3σ Value of Surface Shape (nm) | Rz1/Rz2 (nm) | Fluctuation in Thickness of Resist Film | Imprinting Defects | Total Evaluation |
|---|---|---|---|---|---|
| Example 1 | 1 | 0.5/0.5 | ○ | ○ | ○ |
| Example 2 | 2 | 0.5/0.5 | ○ | ○ | ○ |
| Example 3 | 3 | 0.5/0.5 | ○ | ○ | ○ |
| Comparative Example 1 | 20 | 0.5/0.5 | × | ○ | × |
| Comparative Example 2 | 10 | 0.5/0.5 | × | ○ | × |
| Comparative Example 3 | 8 | 0.5/0.5 | × | ○ | × |
| Comparative Example 4 | 5 | 0.5/0.5 | Δ | ○ | × |
| Comparative Example 5 | 4 | 0.5/0.5 | Δ | ○ | × |
| Comparative Example 6 | 0.5 | 0.5/0.5 | ○ | × | × |

## Claims

1. A nanoimprinting mold produced by forming a fine pattern of protrusions and recesses on the surface of a substrate, wherein:
the surface shape of the substrate after a mold release process is administered thereon and before the pattern of protrusions and recesses is formed is that which has a 3σ value related to a height difference distribution within a range from 1nm to 3nm.

2. A Nanoimprinting mold as defined in Claim 1, wherein:
the 3σ value is within a range from 1nm to 2nm.

3. A nanoimprinting mold as defined in either one of Claim 1 and Claim 2, wherein:
the 3σ value is a value which is calculated as a result of performing measurements of the surface shape over a range having an area of at least 30mm square.

4. A nanoimprinting mold as defined in any one of Claims 1 through 3, wherein:
the substrate having the surface shape is produced employing a Si substrate, formed by performing chemical mechanical polishing on the Si substrate using alkaline colloidal silica and a polyurethane foam pad at a polishing pressure within a range from 60g/cm² to 80g/cm² and a polishing time within a range from 450 seconds to 800 seconds, and then administering a mold release process thereon.

5. A method for producing a nanoimprinting mold in which a fine pattern of protrusions and recesses is formed on the surface of a substrate, wherein:
the surface shape of the substrate after a mold release process is administered thereon and before the pattern of protrusions and recesses is formed is that which has a 3σ value related to a height difference distribution within a range from 1nm to 3nm.

6. A method for producing a nanoimprinting mold as defined in Claim 5, wherein:
a substrate having the 3σ value within a range from 1nm to 2nm is employed as the substrate.

7. A method for producing a nanoimprinting mold as defined in either one of Claim 5 and Claim 6, wherein:
the 3σ value is a value which is calculated as a result of performing measurements of the surface shape over a range having an area of at least 30mm square.

8. A method for producing a nanoimprinting mold as defined in any one of Claims 5 through 7, wherein:
the substrate having the surface shape is produced employing a Si substrate, formed by performing chemical mechanical polishing on the Si substrate using alkaline colloidal silica and a polyurethane foam pad at a polishing pressure within a range from 60g/cm² to 80g/cm² and a polishing time within a range from 450 seconds to 800 seconds, and then administering a mold release process thereon.

9. A nanoimprinting method, comprising:
employing a nanoimprinting mold as defined in any one of Claims 1 through 4;
forming a resist film on a surface to be processed of a member to be processed;
pressing the pattern of protrusions and recesses of the nanoimprinting mold against the resist film, to transfer the pattern of protrusions and recesses onto the resist film; and
separating the nanoimprinting mold from the resist film.
